(19) Europäisches Patentamt
European Patent Office
Office européen des brevets

(11) **EP 1 839 344 B1**

(12) **EUROPÄISCHE PATENTSCHRIFT**

(45) Veröffentlichungstag und Bekanntmachung des Hinweises auf die Patenterteilung:
**01.03.2017 Patentblatt 2017/09**

(51) Int Cl.:
*H01L 33/48* *(2010.01)*    *H01L 33/64* *(2010.01)*
*H01L 33/62* *(2010.01)*

(21) Anmeldenummer: **04741760.5**

(22) Anmeldetag: **09.06.2004**

(86) Internationale Anmeldenummer:
**PCT/EP2004/051066**

(87) Internationale Veröffentlichungsnummer:
**WO 2005/008790 (27.01.2005 Gazette 2005/04)**

(54) **LEUCHTDIODE SOWIE LED-LICHTQUELLE**

LIGHT-EMITTING DIODE AND LED LIGHT SOURCE

DIODE ÉLECTROLUMINESCENTE ET SOURCE DE LUMIÈRE À DEL

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(30) Priorität: **11.07.2003 AT 10722003**

(43) Veröffentlichungstag der Anmeldung:
**03.10.2007 Patentblatt 2007/40**

(60) Teilanmeldung:
**11181590.8 / 2 398 080**

(73) Patentinhaber: **Tridonic Jennersdorf GmbH**
**8380 Jennersdorf (AT)**

(72) Erfinder: **Leising, Günther**
**8042 Graz (AT)**

(74) Vertreter: **Rupp, Christian et al**
**Mitscherlich PartmbB**
**Patent- und Rechtsanwälte**
**Postfach 33 06 09**
**80066 München (DE)**

(56) Entgegenhaltungen:
**WO-A-2004/088760    DE-A1- 19 963 264**
**US-A- 6 043 986    US-A1- 2002 149 102**
**US-B1- 6 531 328**

- **PATENT ABSTRACTS OF JAPAN Bd. 2003, Nr. 08, 6. August 2003 (2003-08-06) & JP 2003 115204 A (TOYODA GOSEI CO LTD), 18. April 2003 (2003-04-18)**
- **PATENT ABSTRACTS OF JAPAN Bd. 018, Nr. 255 (E-1548), 16. Mai 1994 (1994-05-16) & JP 06 037359 A (SHARP CORP), 10. Februar 1994 (1994-02-10)**
- **PATENT ABSTRACTS OF JAPAN Bd. 2003, Nr. 05, 12. Mai 2003 (2003-05-12) & JP 2003 017754 A (ROHM CO LTD), 17. Januar 2003 (2003-01-17)**
- **PATENT ABSTRACTS OF JAPAN Bd. 1997, Nr. 02, 28. Februar 1997 (1997-02-28) & JP 08 264841 A (MATSUSHITA ELECTRON), 11. Oktober 1996 (1996-10-11)**
- **PATENT ABSTRACTS OF JAPAN Bd. 2000, Nr. 06, 22. September 2000 (2000-09-22) & JP 2000 077822 A (KATSURAYAMA TECH), 14. März 2000 (2000-03-14)**
- **PATENT ABSTRACTS OF JAPAN Bd. 1999, Nr. 11, 30. September 1999 (1999-09-30) & JP 11 168235 A (TOYODA GOSEI CO LTD), 22. Juni 1999 (1999-06-22)**
- **PATENT ABSTRACTS OF JAPAN Bd. 009, Nr. 208 (E-338), 24. August 1985 (1985-08-24) & JP 60 072281 A (SANYO DENKI ET AL), 24. April 1985 (1985-04-24)**

## Beschreibung

### Technisches Umfeld

Die vorliegende Erfindung betrifft eine Leuchtdiode (LED), bei der mindestens ein LED-Die mit einem Die-Attach auf einem organischen LED-PCB angeordnet ist (PCB = printed circuit board; der Begriff Die-Attach umfasst sowohl einen Die-Kleber als auch eine Löt-Verbindung) und das LED-PCB an der dem LED-Die gegenüberliegenden Seite elektrische Rückseitenkontakte, die gegebenenfalls als Steckkontakte sind, aufweist. Sie betrifft weiters eine LED-Lichtquelle mit einer oder mehreren auf einer Platine oder einem Stecker angeordneten LEDs der eingangs genannten Art, wobei die Platine Kontaktflächen bzw. der Stecker Kontakte aufweist, mit denen die LEDs kontaktiert sind.

LED-Lichtquellen haben normalerweise folgenden Aufbau:

Der LED-Die ist mittels eines Die-Attachs auf eine Kontaktfläche (z.B. Leiterbahn) eines LED-PCBs aufgebracht. Zusammen mit den Rückseitenkontakten des LED-PCB stellt diese Anordnung eine eigene LED-Lampe dar. Diese LED-Lampe wird mittels einer Bestückungstechnik (z.B. SMT) auf eine Platine assembliert, die dann optional mit einem Kühlkörper verbunden wird. Optional kann die Lampe in einem Lampensockel befestigt und kontaktiert werden. Statt auf einer Platine kann die LED auch auf einem Stecker assembliert werden.

Um LED-Anwendungen mit hoher Helligkeit zu realisieren, werden immer stärkere Hochleistungs-LEDs eingesetzt, auch schon mit einer Betriebsleistung von mehr als 1 $W_{el}$. Die Chipfläche dieser LEDs liegt derzeit im Bereich von 1 $mm^2$. Es zeichnet sich der Trend ab, dass in Zukunft die Betriebsleistung pro LED weiter erhöht wird, was einerseits durch größere Halbleiter und andererseits durch höhere Stromdichten erreicht wird. Speziell letzterer Parameter bewirkt, dass die Leistungsdichten von LEDs von derzeit maximal 1-2 $W_{el}/mm^2$ in Zukunft auf über 4 $W_{el}/mm^2$ ansteigen werden.

Allerdings sind für das Abführen der Verlustwärme hierzu entsprechende Anordnungen zu realisieren, die es gestatten, die Wärme ausreichend vom Halbleiter abzuführen.

Eine zu hohe Erwärmung während des Betriebes der LEDs führt zu einer Bauteilzerstörung. Aus diesem Grund muss während des Betriebes der LED gewährleistet werden, dass die Temperatur an der Sperrschicht des p-n-Übergangs in der LED nicht über typischerweise 130°C steigt. Dies kann insofern während des Betriebes der LEDs eintreten, da nur ein Teil der vom Bauelement aufgenommenen elektrischen Leistung in Licht umgesetzt wird, während der andere Teil in Wärme umgewandelt wird. (Derzeit ist die Leistungseffizienz von LEDs kleiner als 10%.) Die Betriebsparameter von LEDs sind daher in Abhängigkeit von der Art der Assemblierung, der Einbau- und Umgebungsbedingungen derart zu wählen, dass die Sperrschichttemperatur immer unter 130°C bleibt.

In gegenständlicher Erfindung werden Anordnungen vorgestellt, welche die Verlustwärme von LEDs derart effizient abführen können, dass Leistungsdichten von über 2 $W_{el}/mm^2$ abgeführt werden können.

Um die Verlustwärme effizient abzuführen, muss der thermische Widerstand der Anordnung optimiert werden. Wenn die Wärme ohne hohe Temperaturabfälle auf den LED-Träger übertragen werden kann, bleibt die Sperrschicht unter der maximal zulässigen Temperatur. Der wesentliche physikalische Parameter ist also der thermische Widerstand, gemessen in K/W.

Anordnungen und Aufbauten, wie diese derzeit für High-Power-LEDs Stand der Technik sind, weisen in optimierten Anordnungen typisch einen thermischen Widerstand von mehr als 20K/W (Übergang Junction zu LED Trägermaterial) auf. Dies bedeutet, dass der Temperaturunterschied zwischen dem LED-Träger und der aktiven Zone der LED - bei Betrieb mit 5 $W_{el}$- mehr als 100K beträgt. Ausgehend von einer maximal zulässigen Sperrschichttemperatur für Langzeitanwendungen von 130°C bedeutet dies, dass bei Temperaturen über 30°C ein Einsatz unmöglich ist, und daher ist diese LED für viele technische Anwendungen (Automobil, Verkehr) ungeeignet.

JP 2003 115204 A offenbart eine LED-Leuchtquelle vom "shading reflection" Typ mit einer guten Wärmeabfuhr.

JP 06 037359 A und JP 2003 017754 A offenbaren jeweils eine LED mit einem LED-Die auf einem LED-PCB und einem Durchgangsloch in der Nähe des LED-Die.

DE 199 63 264 A1 offenbart eine Metallkernplatine mit Durchkontaktierungen.

US 6,043,986 offenbart ein PCB mit mehreren Durchkontaktierungen, wobei die Durchkontaktierungen einen Durchmesser von mindestens 300 $\mu m$ aufweisen.

US 2002/149102 A1 offenbart eine Struktur und ein Verfahren zum Herstellen von Trägern für LED-Dies mit mehreren Durchkontaktierungen, wobei die Durchkontaktierungen einen Durchmesser von etwa 150 $\mu m$ aufweisen.

### Offenbarung der Erfindung

### Technisches Problem

Es ist Aufgabe der vorliegenden Erfindung, eine LED bzw. eine LED-Lichtquelle der eingangs genannten Art zu schaffen, bei der der thermische Widerstand geringer ist als gemäß dem Stand der Technik.

## Technische Lösung

Diese Aufgabe wird durch eine LED gemäß Anspruch 1 erfindungsgemäß dadurch gelöst, dass die Rückseitenkontakte mindestens die halbe Fläche, vorzugsweise bis auf notwendige Ausnahmen die gesamte Fläche des LED-PCB abdecken. Die notwendigen Ausnahmen sind z.B. die zur elektrischen Isolation notwendigen Beabstandungen von Leiterbahnen auf unterschiedlichem elektrischen Potential. Ferner weist das LED-PCB Durchkontaktierungen zur Erhöhung der Wärmeleitfähigkeit auf, wobei die Durchkontaktierungen einen Durchmesser von weniger als 100 $\mu$m aufweisen.

Bisher wurden die Kontaktflächen immer nur im Hinblick auf den elektrischen Widerstand dimensioniert und daher mit im Verhältnis zur Erfindung geringerer Querschnittsfläche ausgeführt. Erfindungsgemäß sollen diese Kontaktflächen aber möglichst groß sein, wodurch der thermische Widerstand entsprechend herabgesetzt wird. Dabei ist es günstig, dass die thermische und elektrische Leitung senkrecht durch das Trägermaterial durchgeführt wird. Derart kann ein möglichst kompakter Aufbau (ohne räumlich ausgedehnte seitliche Kontakte) realisiert werden.

Es ist günstig, wenn die Rückseitenkontakte mit den Kontaktflächen auf der dem LED-Die zugewandten Seite seitlich des LED-PCB thermisch und gegebenenfalls elektrisch verbunden sind. Dies verbessert nicht nur den thermischen Widerstand, sondern auch die Löt- und Kontaktiereigenschaften.

Bei organischen LED-PCBs bringt man den LED-Die normalerweise auf einer Leiterbahn an. Bei Metallkernplatinen, die nicht Teil der vorliegenden Erfindung sind müssen die Leiterbahnen allerdings gegenüber dem Metallkern isoliert sein. Diese Isolierschicht erhöht natürlich den thermischen Widerstand. Aus diesem Grunde ist es zweckmäßig, dass - wenn es sich bei dem LED-PCB um eine Metallkernplatine handelt - der LED-Die direkt auf dem Metallkern angebracht ist.

Alternativ dazu kann man bei einer Metallkernplatine zwischen den Leiterbahnen und dem Metallkern ein elektrisch nichtlineares Isolatormaterial anordnen. Da LEDs mit relativ geringer Spannung betrieben werden, kann man das Isolatormaterial prinzipiell sehr dünn ausführen, ohne dass im Betrieb ein Durchschlag zu befürchten ist. Allerdings kann beim Hantieren z.B. durch statische Aufladung eine höhere Spannung entstehen, die bei dünnem Isolatormaterial zu einem Durchschlag führen und damit die LED unbrauchbar machen könnte. Dies wird mit einem elektrisch nichtlinearen Isolatormaterial verhindert, weil dieses ab einer bestimmten Spannung leitend wird. Dadurch wird statische Elektrizität abgeleitet, ohne dass ein Schaden entsteht. Mit einem elektrisch nichtlinearen Isolatormaterial kann man also mit einer geringeren Dicke auskommen, was den thermischen Widerstand entsprechend reduziert.

Wenn der LED face-down auf dem LED-Die montiert ist, ist die Lichtausbeute höher, weil dann kein Licht von den sonst notwendigen Bond-Drähten abgeschattet wird.

Bei einer LED-Lichtquelle der eingangs genannten Art wird die oben genannte Aufgabe erfindungsgemäß dadurch gelöst, dass die Rückseitenkontakte der LEDs auf mindestens der halben Fläche des organischen LED-PCBs, vorzugsweise bis auf die notwendigen Ausnahmen vollflächig mit den Kontaktflächen bzw. den Kontakten verlötet sind.

Es ist günstig, wenn auf der Rückseite des organischen LED-PCBs ein Kühlkörper angeordnet ist Dadurch wird die Wärme von der Platine abgeführt, ohne dass dazu Platz auf der Vorderseite der Platine notwendig ist. Der Kühlkörper kann jeglicher metallische Funktionskörper (z.B. ein Gehäuse) und mit beliebiger Verbindungstechnik thermisch mit der Platine verbunden sein.

Das erfindungsgemäße organische LED-PCB weist Durchkontaktierungen zur Erhöhung der Wärmeleitfähigkeit auf, wobei die Durchkontaktierungen einen Durchmesser von weniger als 100 $\mu$m aufweisen. Dies gilt insbesondere für Platinen aus organischem Material, deren thermische Leitfähigkeit an sich schlecht ist.

## Kurze Beschreibung von Zeichnungen

Anhand der beiliegenden Zeichnungen wird die Erfindung näher erläutert. Es zeigt:

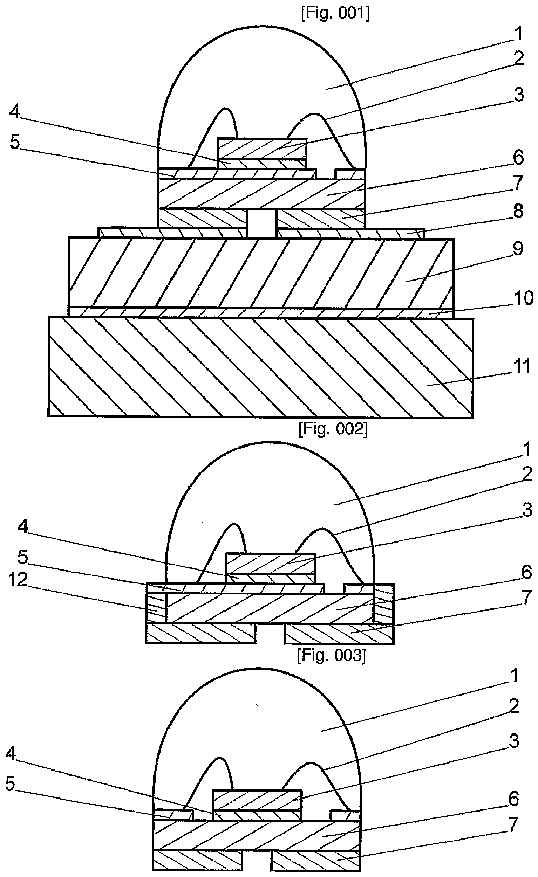

Fig. 1 eine erste Ausführungsform einer erfindungsgemäßen LED-Lichtquelle; Fig. 2 eine Abänderung der in Fig. 1 dargestellten LED; und Fig. 3 eine Abänderung der in Fig. 1 dargestellten LED die nicht Teil der vorliegenden Erfindung ist.

Gemäß Fig. 1 ist ein LED-Die 3 ($R_{th,LED-Die}$) mittels eines Die-Klebers 4 ($R_{th,Die-Kleber}$) auf eine Kontaktfläche (z.B. Leiterbahn 5) eines organischen LED-PCBs 6 ($R_{th,LED-PCB}$) aufgebracht. Der LED-Die 3 in Fig. 1 ist face-up montiert und über Bond-Drähte 2 mit den Kontaktflächen (Leiterbahn 5) verbunden. Alternativ hierzu kann dieser auch in einer Face Down Montage direkt auf dem LED-PCB 6 angeordnet sein bzw. dieser auf einem Die-Träger Face Down befestigt sein, und letzterer dann auf der LED PCB angeordnet sein. Zusammen mit den Rückseitenkontakten 7 ($R_{th,Lötpads}$) des LED-PCB 6 stellt diese Anordnung eine eigene LED-Lampe dar. Zur weiteren Verarbeitung kann diese LED-Lampe mittels einer Bestückungstechnik (z.B. SMT) auf eine Platine 9 ($R_{th,Platine}$) assembliert werden, die dann optional mit einem Kühlkörper 11 verbunden wird, z.B. über eine Lötfläche 10 ($R_{th,Lötfläche}$).

Der LED-Die 3 ist normalerweise in einem Material 1 mit entsprechenden optischen Eigenschaften eingegossen. Der LED-Die kann auch - wie bekannt - in einen Reflektor eingesetzt werden. Selbstverständlich können auch mehrere LED-Dies zusammen eingegossen oder in einen Reflektor eingesetzt werden.

Der typische thermische Widerstand der Gesamtanordnung gemäß Fig. 1 setzt sich wie folgt zusammen:

$$R_{th} = R_{th,LED-Die} \ (4 \ K/W) + R_{th,Die-Kleber} \ (2 \ K/W) + R_{th,LED-PCB} \ (5 \ K/W) + R_{th,Lötpads}$$
$$(3 \ K/W) + R_{th,Platine} \ (2 \ K/W) + R_{th,Lötfläche} \ (2 \ K/W) = 18 \ K/W$$

Um die Verlötungseigenschaften und die Wärmeabfuhr über die Rückseite zu verbessern, ist es (speziell bei organischen PCB s) zweckmäßig, seitliche Kontaktschichten 12 (siehe Fig. 2) auszuführen, die die Oberseite des PCB mit der Unterseite des PCB thermisch und gegebenenfalls elektrisch verbinden. Hierdurch können die Löteigenschaften der LED-Anordnung sowohl bei manuellem Löten als auch in einer automatischen Anlage (SMT Wellen- oder Reflowlöten) durch besseren Lotangriff sowie bessere thermische Verteilung verbessert werden. Weiters ist die Lötstelle besser von außen zu beurteilen.

Fig. 3 zeigt eine Abänderung die nicht Teil der vorliegenden Erfindung ist, gemäß der LED-Die 3 nicht auf eine Leiterbahn aufgesetzt ist, sondern direkt auf den Kern des LED-PCB 6. Dies ist insbesondere bei Metallkernplatinen sinnvoll, weil hier zwischen den Leiterbahnen 5 und dem Metallkern eine dünne Isolationsschicht notwendig ist, um die Leiterbahnen 5 elektrisch zu isolieren. Diese Isolationsschicht erhöht auch den thermischen Widerstand, sodass die direkte Anordnung des LED-Dies 3 auf dem Metallkern des LED-PCB 6 einen kleineren thermischen Widerstand aufweist.

In den Ausführungsbeispielen ist immer von Die-Kleber die Rede, die Dies können aber alternativ dazu auch angelötet sein.

Um den thermischen Widerstand für Hochleistungsanwendungen zu optimieren, sind die thermischen Widerstände der Einzelkomponenten möglichst gering zu halten.

Hierbei ist zu berücksichtigen, dass durch eine Vergrößerung der Fläche der Komponenten nach dem Übergang zum LED-Träger zwar der thermische Widerstand linear abnimmt, anderseits im Hinblick auf eine hohe Integrationsdichte eine Vergrößerung dieser Fläche für viele Anwendungen unerwünscht ist

Es ist daher günstiger, die materialspezifische thermische Leitfähigkeit der einzelnen Materialien zu optimieren bzw. darüber hinaus die Schichtdicke der Komponenten möglichst dünn zu wählen.

Folgende Möglichkeiten bieten sich an:

I Einsatz von Leitkleber d < 10 μm mit Leitfähigkeit über 2 W/mK
II Einsatz von Lötkontaktschichten mit thermischer Leitfähigkeit über 20 W/mK und einer Schichtdicke unter 30 μm
Organische PCBs

Im Gegensatz zu Keramiken und Metallkernplatinen ist die thermische Leitfähigkeit des Trägermaterials eines organischen PCB sehr schlecht (nur 0,1-0,2 W/mK). Um mit diesen Materialien dennoch eine ausreichende thermische Leitfähigkeit zu realisieren, sind in der unmittelbaren Nähe des Die Durchkontaktierungen vorgesehen, die zumindest teilweise mit Cu gefüllt sind. Je höher die Anzahl der Durchkontaktierungen, umso geringer wird der thermische Widerstand. Um die Wärme hierzu ausreichend zu spreizen, ist aus dem Stand der Technik bekannt, dass Metallisierungs-schichtdicken von über 100 μm, bevorzugt über 200 μm notwendig sind. Typischerweise weisen diese Kanäle einen Durchmesser von einigen Zehntel mm auf. Erfindungsgemäß beträgt der Durchmesser der Kanäle aber weniger als 100 μm, bevorzugt nur wenige Mikro- oder Nanometer. Derart wird ein Substrat mit sehr hoher anisotroper elektrischer und thermischer Leitfähigkeit realisiert.

**Patentansprüche**

1. Leuchtdiode, bei der mindestens ein LED-Die (3) mit einem Die-Attach (4) auf einem organischen LED-PCB (6) angeordnet ist und das organische LED-PCB (6) an der dem LED-Die (3) gegenüberliegenden Seite elektrische Rückseitenkontakte (7), die gegebenenfalls als Steckkontakte ausgebildet sind, aufweist, **dadurch gekennzeichnet, dass**
die Rückseitenkontakte (7) mindestens die halbe Fläche, vorzugsweise bis auf notwendige Ausnahmen die gesamte Fläche des organischen LED-PCBs (6) abdecken, und
das organische LED-PCB (6) Durchkontaktierungen zur Erhöhung der Wärmeleitfähigkeit aufweist, wobei die Durchkontaktierungen einen Durchmesser von weniger als 100 μm aufweisen.

**2.** Leuchtdiode nach Anspruch 1, **dadurch gekennzeichnet, dass** die Rückseitenkontakte (7) mit den Kontaktflächen (5) auf der dem LED-Die zugewandten Seite seitlich des organischen LED-PCBs (6) thermisch und gegebenenfalls elektrisch verbunden sind.

**3.** Leuchtdiode nach einem der Ansprüche 1 oder 2, **dadurch gekennzeichnet, dass**
der LED-Die (3) face-down auf dem organischen LED-PCB (6) montiert ist.

**4.** LED-Lichtquelle mit einer oder mehreren auf einer Platine (9) oder einem Stecker angeordneten LEDs nach einem der Ansprüche 1 bis 3, wobei die Platine (9) Kontaktflächen (8) bzw. Stecker Kontakte aufweist, mit denen die LEDs kontaktiert sind, **dadurch gekennzeichnet, dass**
die Rückseitenkontakte (7) der LEDs auf mindestens der halben Fläche des organischen LED-PCBs (6), vorzugsweise bis auf die notwendigen Ausnahmen vollflächig mit den Kontaktflächen (8) bzw. mit den Kontakten verlötet sind, auf der Rückseite der Platine (9) ein Kühlkörper (11) angeordnet ist, und
das organische LED-PCB (6) Durchkontaktierungen zur Erhöhung der Wärmeleitfähigkeit aufweist, wobei die Durchkontaktierungen einen Durchmesser von weniger als 100 $\mu$m aufweisen.

**5.** LED-Lichtquelle nach Anspruch 4,
bei der die Platine (9) Durchkontaktierungen zur Erhöhung der Wärmeleitfähigkeit aufweist, wobei die Durchkontaktierungen einen Durchmesser von weniger als 100 $\mu$m aufweisen.

**Claims**

**1.** A light-emitting diode,
in which at least one LED die (3) with a die attach (4) is arranged on an organic LED-PCB (6) and the organic LED-PCB (6) has electrical backside contacts (7) on the side located opposite the LED die (3), which are designed, if need be, as plug-in contacts,
**characterized in that**
the backside contacts (7) cover at least half the surface, preferably, apart from necessary exceptions, the entire surface of the organic LED-PCB (6), and
the organic LED-PCB (6) has through-hole plates for increasing the thermal conductivity, wherein the through-hole plates have a diameter of less than 100 $\mu$m.

**2.** A light-emitting diode according to Claim 1, **characterized in that** the backside contracts (7) are connected thermally and, if need be, electrically with the contact surfaces (5) on the side facing the LED die at the side of the organic LED-PCB (6).

**3.** A light-emitting diode according to one of Claims 1 or 2, **characterized in that** the LED die (3) is mounted face-down on the organic LED-PCB (6).

**4.** A LED light source with one or several LEDs arranged on a board (9) or a plug according to one of Claims 1 to 3, wherein the board (9) has contact surfaces (8) or plug contacts, with which the LEDs are contacted, **characterized in that**
the backside contacts (7) of the LEDs are soldered on at least the half surface of the organic LED-PCB (6), preferably, apart from the necessary exceptions, fully with the contact surfaces (8) or with the contacts,
on the backside of the board (9) a cooling element (11) is arranged, and
the organic LED-PCB (6) has through-hole plates for increasing the thermal conductivity, wherein the through-hole plates have a diameter of less than 100 $\mu$m.

**5.** A LED light source according to Claim 4,
in which the board (9) has through-hole plates for increasing the thermal conductivity,
wherein the through-hole plates have a diameter of less than 100 $\mu$m.

**Revendications**

**1.** Diode électroluminescente,
dans laquelle une puce de DEL (3) au moins au nombre de un est disposée sur une carte à circuit imprimé de DEL (6) organique avec une fixation de DEL (4), et la carte à circuit imprimé de DEL (6) organique présente, sur le côté opposé à la puce de DEL (3) des contacts de face arrière (7) électriques qui sont éventuellement constitués en tant que fiches de contact, **caractérisée en ce que**
les contacts de face arrière (7) recouvrent au moins la demi-surface, de préférence la surface totale à quelques exceptions près nécessaires, de la carte à circuit imprimé de DEL (6) organique, et la carte à circuit imprimé de DEL (6) organique présente des vias destinés à augmenter la conductibilité thermique, les vias présentant un diamètre inférieur à 100 $\mu$m.

2. Diode électroluminescente selon la revendication 1, **caractérisée en ce que**
les contacts de face arrière (7) sont raccordés thermiquement et éventuellement électriquement aux surfaces de contact (5) sur le côté tourné vers la puce de DEL, latéralement par rapport à la carte à circuit imprimé de DEL (6) organique.

3. Diode électroluminescente selon l'une des revendications 1 ou 2, **caractérisée en ce que**
la puce de DEL (3) est montée face vers le bas sur la carte à circuit imprimé de DEL (6) organique.

4. Source de lumière à DEL avec une ou plusieurs DEL disposées sur une platine (9) ou sur un connecteur selon l'une des revendications 1 à 3, la platine (9) présentant des surfaces de contact (8) ou respectivement des connecteurs contacts avec lesquels les DEL sont mises en contact, **caractérisée en ce que**
les contacts de face arrière (7) des DEL sont, sur au moins la moitié de la surface, de préférence sur la surface totale à quelques exceptions près nécessaires, de la carte à circuit imprimé de DEL (6) organique, assemblés par soudage avec les surfaces de contact (8) ou respectivement avec les contacts,
un dissipateur thermique (11) est disposé sur le côté arrière de la platine (9), et
la carte à circuit imprimé de DEL (6) organique présente des vias destinés à augmenter la conductibilité thermique, les vias présentant un diamètre inférieur à 100 $\mu$m.

5. Source de lumière à DEL selon la revendication 4,
dans laquelle la platine (9) présente des vias destinés à augmenter la conductibilité thermique, les vias présentant un diamètre inférieur à 100 $\mu$m.

[Fig. 001]

1
2
3
4
5
6
7
8
9
10
11

[Fig. 002]

1
2
3
4
5
12
6
7

[Fig. 003]

1
2
3
4
5
6
7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2003115204 A
- JP 6037359 A
- JP 2003017754 A

- DE 19963264 A1
- US 6043986 A
- US 2002149102 A1